(19) **Europäisches Patentamt / European Patent Office / Office européen des brevets**

(11) **EP 2 454 861 B1**

(12) **FASCICULE DE BREVET EUROPEEN**

(45) Date de publication et mention
de la délivrance du brevet:
**05.03.2014 Bulletin 2014/10**

(21) Numéro de dépôt: **10736756.7**

(22) Date de dépôt: **13.07.2010**

(51) Int Cl.:
*H04L 27/227* (2006.01)　　*H04L 27/233* (2006.01)
*H03M 1/12* (2006.01)　　*H04L 27/06* (2006.01)

(86) Numéro de dépôt international:
**PCT/FR2010/000505**

(87) Numéro de publication internationale:
**WO 2011/007057 (20.01.2011 Gazette 2011/03)**

(54) **Réduction de la sensibilité de la démodulation à la gigue du signal d'horloge d'échantillonage**

Verringerung der Sensitivität der Jitterdemodulation eines Abtasttaktsignals

Reduction of the sensitivity of jitter demodulation of a sampling clock signal

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **15.07.2009 FR 0903455**

(43) Date de publication de la demande:
**23.05.2012 Bulletin 2012/21**

(73) Titulaire: **Commissariat à l'Énergie Atomique et aux Énergies Alternatives
75015 Paris (FR)**

(72) Inventeur: **GALDEMARD, Philippe
F-78720 La Celle Les Bordes (FR)**

(74) Mandataire: **Priori, Enrico et al
Cabinet Orès
36, rue de St. Pétersbourg
75008 Paris (FR)**

(56) Documents cités:
**US-A- 5 937 013**

Printed by Jouve, 75001 PARIS (FR)

**Description**

L'invention porte sur un procédé et un circuit de démodulation d'un signal radiofréquence, permettant de déterminer une information de phase et/ou d'amplitude dudit signal. L'invention présente des nombreuses applications potentielles, en particulier dans le domaine des accélérateurs de particules, mais également des télécommunications.

Le traitement des signaux modulant une porteuse radiofréquence (RF) par des systèmes numériques tels des processeurs, des FGPA (« *Field-Programmable Gate Array* », c'est à dire réseau de portes programmables in situ), etc., nécessite, en amont de ces systèmes, une chaine de réception et d'acquisition des signaux. Le passage du signal analogique RF aux données utilisables par le processeur ou le FPGA se fait habituellement à l'aide d'un ou de plusieurs convertisseurs analogique-numérique (ADC, de l'anglais « *Analog to Digital Converter* »), éventuellement après transposition du signal analogique à une fréquence intermédiaire plus basse. La gigue (ou jitter) de l'horloge d'échantillonnage qui actionne le circuit échantillonneur-bloqueur devient une source majeure de bruit pour les mesures, dès que la fréquence de du signal échantillonné est assez élevée. Voir à ce propos le document [1].

En particulier, pour simplifier l'électronique d'acquisition des signaux RF, il est parfois souhaitable de pratiquer l'échantillonnage direct du signal RF, sans transposition de fréquence. En effet, en plus de son coût supplémentaire, l'étage de transposition de fréquence est délicat à mettre en oeuvre, et génère des distorsions du signal et du bruit additionnel. Pour ces systèmes où l'on souhaite supprimer l'étage de transposition de fréquence, l'échantillonnage direct impose d'échantillonner des signaux analogiques de fréquence élevée, pour lesquels la gigue de l'horloge d'échantillonnage devient une source majeure de bruit et limite la précision des mesures.

La gigue d'un signal d'horloge est l'écart aléatoire du temps d'arrivée des fronts de ce signal par rapport à une horloge idéale de même fréquence. Pour tous les systèmes qui échantillonnent un signal variant assez rapidement dans le temps comme des signaux radiofréquence, la gigue de l'horloge d'échantillonnage se traduit par une erreur de mesure significative et aléatoire, d'autant plus grande que vitesse de variation du signal échantillonné est grande, donc d'autant plus gênante que la fréquence du signal analogique échantillonné est élevée.

De nombreux dispositifs ont été étudiés ou développés pour réduire la gigue des signaux d'horloge, non seulement parce qu'elle limite la précision des convertisseurs analogique-numériques travaillant sur des signaux analogiques de fréquence élevée, mais surtout parce qu'elle limite la fréquence de fonctionnement des circuits logiques numériques. Parmi les dispositifs les plus populaires, on trouve les boucles à verrouillage de phase, ou PLL (« *Phase-Locked Loop* »), qui peuvent même être incluses dans les fonctionnalités offertes par les circuits intégrés complexes comme les FPGA.

Le chapitre 1 du document [2] décrit l'effet de la gigue d'une horloge d'échantillonnage ainsi que l'utilisation d'une PLL ou d'un circuit dédié (« circuit d'atténuation de la gigue ») pour diminuer cette gigue. Malheureusement les meilleurs circuits numériques actuels, à base de PLL ou autres, produisent des horloges dont la gigue est d'au mieux quelques picosecondes (ps) en moyenne quadratique (« *root mean square* », ou « *rms* »). Elle est par exemple d'environ 20 ps rms pour le FPGA Xilinx Virtex-5.

Pour les systèmes numériques demandant une très grande précision dans la mesure de la phase d'un signal RF, une horloge avec une telle gigue ne peut pas être utilisée pour échantillonner le signal directement, dès que la fréquence RF est assez haute. Par exemple, dans le cas d'un accélérateur de particules qui aurait une fréquence de fonctionnement de 1 GHz, une gigue d'horloge de 20 ps rms limiterait la mesure brute de phase du signal RF par échantillonnage IQ direct à environ 7° rms, alors que la spécification de régulation en phase de tels accélérateurs est plutôt de l'ordre de +/-1° voire beaucoup moins. Comme autre exemple on peut citer le futur accélérateur XFEL, pour lequel la stabilité requise des champs RF à 1,3 GHz est de l'ordre de 0,01° en phase et de 0.01% en amplitude (voir le document [3]).

Dans les dispositifs actuels, pour améliorer la précision sur ces mesures de signaux RF, on a recours à une ou plusieurs des solutions techniques suivantes, qui peuvent le cas échéant être utilisées simultanément :

(1) Utilisation d'une horloge faible gigue, lorsqu'elle peut être mise en oeuvre.
(2) Recours à un dispositif mélangeur, qui permet de transposer le signal à une fréquence intermédiaire (notée IF, pour « Intermediate Frequency », dans la suite) plus basse.
(3) Calcul de la moyenne temporelle d'un certain nombre d'échantillons successifs pour améliorer le rapport signal à bruit.

La solution (1) implique en général que l'horloge soit synthétisée en dehors des composants numériques mis en oeuvre sur les cartes électroniques RF qui font l'acquisition et le traitement des signaux. Cette solution nécessite donc des composants supplémentaires qui ne sont pas forcément intégrables facilement sur ces cartes électroniques. C'est la solution qui a été retenue pour permettre l'échantillonnage direct des tensions RF à 88 MHz, dans le projet Spiral-2 (voir le document [4]).

La solution (2) est couramment employée dans les accélérateurs de particules. La transposition de fréquence permet de créer un signal analogique de fréquence intermédiaire IF bien inférieure à celle du signal RF d'origine, mais qui conserve toute l'information d'amplitude et de phase de ce signal. Mais l'étage de transposition de fréquence est un dispositif délicat à mettre en oeuvre, coûteux, sensible à la température, et générant du bruit additionnel et des harmoniques parasites. L'emploi de cette solution dans les accélérateurs de particules est aussi lié au fait que les convertisseurs analogiques-numériques de résolution suffisante (12-14 bits) ont longtemps présenté une bande passante analogique trop faible par rapport à la fréquence de fonctionnement des accélérateurs. Ceci est en train d'évoluer avec l'apparition sur le marché de codeurs 14 bits avec une bande passante analogique supérieure à 1 GHz (Par exemple : Analog Devices ADC14DS105, ou Texas Instruments ADS5474).

La solution (3), qui peut être réalisée techniquement de plusieurs façons (par exemple, voir le document [5]) ne peut être mise en oeuvre que lorsque le temps disponible pour effectuer la mesure le permet. Dans les accélérateurs, cette technique est parfois utilisée, mais son apport est limité du fait du faible temps de latence autorisé pour les boucles de régulation RF, ce qui limite le nombre d'échantillons pouvant être moyennés. De plus, le bruit dû à la gigue de l'horloge de conversion n'est pas un bruit blanc, et l'amélioration du rapport Signal à bruit en prenant la moyenne de N échantillons est en général bien inférieure au facteur $\sqrt{N}$ escompté dans le cas d'un bruit blanc.

L'invention vise à procurer un procédé et un circuit de démodulation d'un signal radiofréquence ne présentant pas les inconvénients précités de l'art antérieur. L'invention se base sur les techniques bien connues d'échantillonnage IQ et non-IQ et procède de la découverte que la sensibilité de ces techniques à la gigue du signal d'horloge d'échantillonnage dépend fortement de la phase du signal radiofréquence. L'invention s'applique notamment à la démodulation de signaux dont la porteuse, éventuellement après conversion de fréquence, présente une fréquence relativement élevée, de l'ordre de 100 MHz ou plus, voire supérieure ou égale à 1 GHz.

Un objet de l'invention est donc un procédé de démodulation d'un signal radiofréquence comportant les étapes consistant à : procurer un signal d'horloge d'échantillonnage synchrone dudit signal radiofréquence à démoduler ; échantillonner ledit signal radiofréquence au moyen dudit signal d'horloge d'échantillonnage ; et traiter les échantillons ainsi obtenus pour déterminer la phase et/ou l'amplitude dudit signal radiofréquence ; ce procédé étant caractérisé en ce qu'il comporte également une étape d'ajustement de la phase, mesurée par rapport au signal d'horloge d'échantillonnage, dudit signal à démoduler et/ou d'un signal synchrone de référence par rapport auquel ce signal est démodulé, de manière à minimiser l'erreur de phase et/ou d'amplitude provoqué par une gigue dudit signal d'horloge d'échantillonnage.

Selon des modes de réalisation particuliers du procédé de l'invention :

- Ledit signal radiofréquence peut présenter une porteuse à une fréquence $f_{RF}$ tandis que ledit signal d'horloge d'échantillonnage présente une fréquence $f_S = N_1/N_2 \cdot f_{RF}$ où $N_1$ et $N_2$ sont des entiers naturels différents tels qu'il n'existe pas d'entier naturel non nul $N_3$ pour lequel $N_1/N_2=2/N_3$ (autrement dit, tels que la période du signal d'échantillonnage ne soit pas multiple de la demi-période du signal à échantillonner).
- En particulier, ledit signal d'horloge d'échantillonnage peut présenter une fréquence $f_S = 4/(2k+1) \cdot f_{RF}$ où k est un entier naturel, moyennant quoi ledit échantillonnage est un échantillonnage de type IQ.
- En variante, ledit signal d'horloge d'échantillonnage peut présenter une fréquence $f_S=N_1/N_2 \cdot f_{RF} \neq 4/(2k+1) \cdot f_{RF}$ où k est un entier naturel, moyennant quoi ledit échantillonnage est un échantillonnage de type non-IQ.
- Avantageusement, la phase dudit signal radiofréquence, mesurée par rapport au signal d'échantillonnage, peut être ajustée à une valeur aussi proche que possible d'une valeur cible choisie entre :

  ■ $\pm k\pi/2$ avec k entier, de manière à minimiser l'erreur de mesure d'amplitude provoquée par la gigue dudit signal d'horloge d'échantillonnage ; et
  ■ $\pi/4 \pm k\pi/2$ avec k entier, de manière à minimiser l'erreur de mesure de phase provoquée par la gigue dudit signal d'horloge d'échantillonnage.

En général, la valeur cible ne pourra pas être atteinte de manière exacte en raison des inévitables erreurs de calibrage mais aussi, lorsque la phase est ajustée en utilisant un déphaseur numérique, de la résolution finie dudit déphaseur.

- Le procédé peut comporter l'échantillonnage IQ dudit signal radiofréquence dit signal principal ainsi que d'un second signal radiofréquence synchrone avec ledit signal principal, dit signal de référence, et le traitement des échantillons ainsi obtenus pour déterminer les variations de phase dudit signal principal par rapport audit signal de référence, dans lequel la phase $\varphi_{RF}$ de la porteuse dudit signal principal et la phase $\varphi_{REF}$ dudit signal de référence sont ajustées de manière à minimiser l'erreur de mesure de la grandeur $\left(\varphi_{RF} - \dfrac{f_{RF}}{f_{REF}}\varphi_{REF}\right)$, où $f_{REF}$ est la fréquence du signal de référence, qui est commensurable avec celle du signal principal.

- Avantageusement la phase $\varphi_{RF}$ dudit signal principal et celle $\varphi_{REF}$ dudit signal de référence peuvent être ajustées de manière à approcher autant que possible la relation $\varphi_{REF}=\pm\varphi_{RF}\pm k\pi$ avec k entier. En particulier, la phase $\varphi_{RF}$ dudit signal principal et celle $\varphi_{REF}$ dudit signal de référence peuvent être ajustées de manière à approcher autant que possible les relations : $\varphi_{RF} = \pm k\pi/2$ et $\varphi_{REF} = \pm\varphi_{RF}\pm k'\pi$ avec k, k' entiers. En général, ces relations ne pourront pas être satisfaites exactement en raison des inévitables erreurs de calibrage mais aussi, lorsque les phases sont ajustées en utilisant un ou plusieurs déphaseurs numériques, de la résolution finie de ce ou ces déphaseurs.

- En variante le procédé peut comporter l'échantillonnage non-IQ d'un premier signal radiofréquence dit signal principal ainsi que d'un second signal radiofréquence synchrone avec ledit signal principal, dit signal de référence, et le traitement des échantillons ainsi obtenus pour déterminer les variations de phase dudit signal principal par rapport audit signal de référence, dans lequel la phase $\varphi_{RF}$ de la porteuse dudit signal principal et la phase $\varphi_{REF}$ dudit signal de référence sont ajustées de manière à minimiser l'erreur de mesure de la grandeur $\left(\varphi_{RF} - \dfrac{f_{RF}}{f_{REF}}\varphi_{REF}\right)$, où $f_{REF}$ est la fréquence du signal de référence, qui est commensurable avec celle du signal principal.

En particulier, la phase $\varphi_{RF}$ dudit signal principal et celle $\varphi_{REF}$ dudit signal de référence peuvent être ajustées de manière à approcher autant que possible la relation $\varphi_{REF}=\varphi_{RF}\pm k\pi$ avec k entier. La encore, en général, cette relation ne pourra pas être satisfaite exactement en raison des inévitables erreurs de calibrage mais aussi, lorsque les phases sont ajustées en utilisant un ou plusieurs déphaseurs numériques, de la résolution finie de ce ou ces déphaseurs.

- La porteuse dudit signal principal et ledit signal de référence peuvent être à la même fréquence. En variante, ces signaux peuvent être synchrones, c'est à dire présenter des fréquences commensurables (ayant un rapport rationnel), mais en général différentes.

- Ledit ajustement de phase peut être obtenu au moyen d'au moins un déphaseur. En particulier, ledit ajustement de phase peut être obtenu au moyen d'au moins deux déphaseurs prévus pour introduire des déphasages indépendants dudit signal principal et dudit signal de référence.

Encore un autre objet de l'invention est un circuit démodulateur comportant: une première entrée pour un signal radiofréquence à démoduler; un générateur de signal d'horloge d'échantillonnage synchrone dudit signal radiofréquence; un premier échantillonneur dudit signal radiofréquence, piloté par ledit signal d'horloge d'échantillonnage ; et des moyens de traitement des échantillons ainsi obtenus pour déterminer la phase et/ou l'amplitude dudit signal radiofréquence ; ledit circuit étant caractérisé en ce qu'il comporte au moins un déphaseur ajustable dudit signal radiofréquence, d'un signal de référence synchrone par rapport auquel ce signal est démodulé et/ou dudit signal d'horloge d'échantillonnage.

Avantageusement un tel circuit peut comporter également une entrée pour un second signal radiofréquence, dit signal de référence ; et un second échantillonneur, piloté par ledit signal d'horloge d'échantillonnage, pour échantillonner ledit signal de référence ;lesdits moyens de traitement des échantillons pouvant être adaptés pour déterminer une information de phase relative dudit signal principal par rapport audit signal de référence à partir des échantillons fournis par lesdits premier et second échantillonneurs. Ledit générateur de signal d'horloge d'échantillonnage peut être piloté par ledit signal de référence.

Le circuit de l'invention peut comporter également des moyens de commande pour ajuster ledit ou chaque déphaseur de manière à maintenir la phase et/ou la différence de phase dudit signal principal et dudit signal de référence à l'intérieur d'une plage de valeurs prédéterminée.

Avantageusement, ce circuit peut comporter au moins deux déphaseurs agencés pour introduire des déphasages indépendants dudit signal principal et dudit signal de référence.

D'autres caractéristiques, détails et avantages de l'invention ressortiront à la lecture de la description faite en référence aux dessins annexés donnés à titre d'exemple et qui représentent, respectivement :

- la figure 1, le schéma de principe d'un circuit démodulateur connu de l'art antérieur, basé sur le simple échantillonnage IQ ;

- la figure 2, le schéma de principe d'un circuit démodulateur connu de l'art antérieur, basé sur le double échantillonnage IQ ;

- les figures 3A, 3B et 4 à 7, des graphiques illustrant l'influence de la phase du signal radiofréquence et, pour les figures 4 à 7, du signal de référence, sur l'erreur de mesure de phase/amplitude introduit par la gigue ; et

- les figures 8 à 11, des schémas de principe de circuits selon différents modes de réalisation de l'invention.

La description détaillée de l'invention doit être précédée par un rappel des techniques, connues par elles-mêmes, d'échantillonnage (simple ou double) IQ et non-IQ.

L'échantillonnage IQ est une méthode couramment utilisée pour acquérir les paramètres des signaux RF (c'est à dire les démoduler), et réaliser des traitements numériques sur ces paramètres.

Un signal RF modulé, noté $Y(t)$, peut s'écrire : $Y(t) = A(t) \times \cos(\omega t - \varphi(t))$, $A(t)$ et $\varphi(t)$ étant respectivement l'amplitude et la phase instantanées, $\omega = 2\pi f_{RF}$ la pulsation de la porteuse RF à la fréquence $f_{RF}$, et le temps étant désigné par la variable t.

Ce signal peut être décomposé à tout instant en ses composantes I est Q selon l'équivalence :

$$Y(t) = A(t) \times \cos(\omega t - \varphi(t)) \Leftrightarrow \begin{cases} Y(t) = I(t) \times \cos(\omega t) + Q(t) \times \sin(\omega t) \\ I(t) = A(t) \times \cos(\varphi(t)) \\ Q(t) = A(t) \times \sin(\varphi(t)) \end{cases}$$

$I(t)$ et $Q(t)$ sont appelées respectivement composantes en phase et en quadrature du signal. Mesurer et donc connaître $I$ et $Q$, est équivalent à connaître l'amplitude et la phase du signal observé, d'après l'équivalence précédente. Il faut noter que l'on trouve parfois dans la littérature d'autres conventions pour la définition des composantes $I$ et $Q$.

Il est immédiat de vérifier que l'échantillonnage du signal aux instants $\omega t = 0 + 2k\pi$, $\omega t = \pi / 2 + 2k\pi$, $\omega t = \pi + 2k\pi$, et $\omega t = 3\pi / 2 + 2k\pi$, fournit directement et successivement les valeurs de $I$, $Q$, $-I$, $-Q$, lorsque k décrit l'ensemble des entiers naturels.

A partir des valeurs de $I$ et $Q$, déterminées par échantillonnage du signal, on peut calculer l'amplitude et la phase en appliquant les relations:

$$\begin{cases} A = \sqrt{I^2 + Q^2} \\ \cos(\varphi) = \dfrac{I}{\sqrt{I^2 + Q^2}} \\ \sin(\varphi) = \dfrac{Q}{\sqrt{I^2 + Q^2}} \end{cases}$$

Numériquement, connaissant $I$ et $Q$, on peut calculer $A$ et de plusieurs façons, notamment par :

$$\begin{cases} A = \sqrt{I^2 + Q^2} \\ \varphi = \text{signe}(Q) \times \arccos(\dfrac{I}{\sqrt{I^2 + Q^2}}) \end{cases}$$

ou, de manière équivalente, par :

$$\begin{cases} A = \sqrt{I^2 + Q^2} \\ \varphi = \arcsin\left(\dfrac{Q}{\sqrt{I^2 + Q^2}}\right) \text{ si } I > 0 \\ \varphi = \text{signe}(Q) \times \pi - \arcsin\left(\dfrac{Q}{\sqrt{I^2 + Q^2}}\right) \text{ si } I < 0 \end{cases}$$

Où *signe(x)* désigne la fonction suivante :

$$signe(x) = -1 \: pour \: x < 0 \: et \: signe(x) = +1 \: pour \: x \geq 0 \,.$$

Concernant la fréquence de l'horloge d'échantillonnage, qui doit être synchrone de la fréquence de la porteuse RF, on peut prendre toutes les fréquences $f_s$ telles que :

$$f_s = \frac{4}{(2k+1)} f_{RF} \,,$$

avec $k$ entier quelconque positif.

Selon les valeurs de k, on obtient successivement *I, Q, -I, -Q* ou bien *I, -Q, -I, Q*.

Les techniques d'échantillonnage IQ et des dispositifs physiques associés ont été abondamment décrits dans la littérature, par exemple dans les documents [6] et [7].

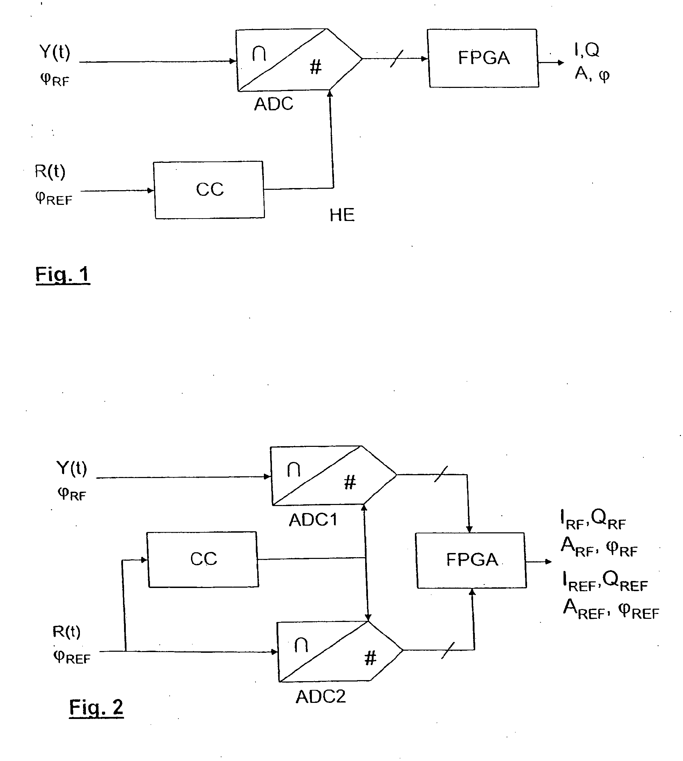

Lorsque l'on applique cette méthode dite de simple échantillonnage, l'origine des temps est fixée arbitrairement à l'instant d'un échantillon particulier, et la mesure de la phase du signal se fait donc par rapport à l'horloge d'échantillonnage. Dans certains cas, comme dans le cas du contrôle des champs RF des multiples cavités accélératrices d'un accélérateur de particules, il faut réguler la phase du champ de chaque cavité par rapport à une référence RF commune à toutes les cavités. Ceci implique que la mesure de la phase du signal soit faite par rapport à celle de la référence RF, et donc que l'horloge d'échantillonnage soit synchrone de cette dernière. En pratique, les fréquences de la référence RF et du signal RF ont une relation simple (rationnelle) entre elles, et le circuit qui génère l'horloge d'échantillonnage à partir de la référence consiste en une simple PLL numérique ou bien est constitué par des diviseurs et des multiplieurs analogiques de fréquence. Le schéma général de la démodulation IQ par simple échantillonnage est donné figure 1 où

- Y(t) représente le signal RF à démoduler (« signal principal ») ;
- R(t) représente le signal RF de référence ;
- ADC représente un bloc échantillonneur-bloqueur-convertisseur analogique/numérique ;
- CC représente un circuit générateur d'un signal d'horloge d'échantillonnage HE, synchrone avec le signal de référence (et donc avec la porteuse du signal principal Y) ; et
- FPGA représente un circuit numérique de traitement, qui peut être justement un FPGA ou bien un processeur.

Un problème du simple échantillonnage est que la mesure de la phase du signal RF n'est pas faite directement par rapport à la référence RF, mais par rapport à l'horloge d'échantillonnage. Si le circuit de production de l'horloge dérive en phase, par exemple selon la température, alors cette dérive se retrouve intégralement sur la mesure, ce qui n'est pas tolérable dans les applications où l'on souhaite justement asservir la phase du signal observé à une valeur constante, comme dans les accélérateurs de particules.

Un second problème, est le choix de l'échantillon considéré comme la première valeur de I, ce qui équivaut au choix de l'instant t=0. Si ce choix est arbitraire, alors on obtient d'une mesure à l'autre, une indétermination de la phase, à des multiples de $\pi/2$ près.

Ces deux problèmes sont facilement évacués par le double échantillonnage, pratiqué dans de nombreux accélérateurs. Voir par exemple le document [9].

Le double échantillonnage IQ consiste à échantillonner également la référence RF, à la même fréquence d'échantillonnage, et avec la même horloge. Comme montré sur la figure 2, un circuit de double échantillonnage comporte deux blocs échantillonneur-bloqueur-convertisseur analogique/numérique, ADC1 et ADC2. Un tel circuit permet de mesurer les composantes $I_{RF}$ et $Q_{RF}$ du signal RF, et les composantes $I_{REF}$ et $Q_{REF}$ de la référence, chacune par rapport à l'horloge d'échantillonnage. Par application des formules ci-dessus, puis par soustraction, on peut donc calculer la différence de phase $\varphi_{RF} - \varphi_{REF}$ où $\varphi_{RF}$ est la phase du signal principal Y et $\varphi_{REF}$ la phase du signal de référence. Cette différence de phase ne dépend plus de la dérive en phase de l'horloge d'échantillonnage, ni de l'instant 0 du début des acquisitions.

Dans les systèmes de régulation numériques, on peut avoir intérêt à ne pas repasser en coordonnées polaires, mais à rester dans le domaine (I, Q), principalement pour des raisons de rapidité de calcul ou bien pour éviter les discontinuités qui se produisent en +/- $\pi$ lorsque l'on applique les formules donnant A et $\varphi$ en fonction de I et Q. Ceci se fait par exemple en appliquant les formules :

$$\begin{cases} I = \dfrac{(I_{RF} \times I_{REF} + Q_{RF} \times Q_{REF})}{A_{REF}} \\ Q = \dfrac{(Q_{RF} \times I_{REF} - I_{RF} \times Q_{REF})}{A_{REF}} \end{cases}$$

où $A_{REF}$ représente l'amplitude de la référence. $I$ et $Q$ représentent alors les composantes d'un signal ayant pour amplitude celle du signal RF mesuré, et pour phase la différence de phase entre signal RF et référence RF. De façon équivalente à la formulation précédente, on s'est donc affranchi dans cette mesure des dérives en phase de l'horloge d'échantillonnage, et du choix de l'instant t=0 du début des acquisitions.

Il est possible de généraliser la notion d'échantillonnage IQ et parler d'échantillonnage « synchrone ». On a un échantillonnage synchrone lorsque la fréquence d'échantillonnage est « synchrone » de la fréquence RF du signal d'intérêt, autrement dit lorsque $f_{RF}$ et $f_S$ sont commensurables, c'est à dire que leur rapport est un nombre rationnel :

$$f_s = \frac{N_1}{N_2} f_{RF}$$ avec Ni, $N_2$ entiers naturels. Dans ce cas, on peut définir un angle $\alpha$ qui correspond à la différence de phase séparant deux échantillons successifs :

$$\alpha = 2\pi \frac{N_2}{N_1}$$

Lorsque l'échantillonnage du signal RF (simple ou double) se fait à une fréquence telle que les échantillons consécutifs sont séparés d'un angle $\alpha = (2n - 1)\dfrac{\pi}{2}$, avec n entier quelconque positif, on parle d'échantillonnage IQ.

Dans les autres cas on parle d'échantillonnage « non-IQ ». On notera que si $f_s = \dfrac{2}{N} f_{RF}$ il n'est pas possible de déterminer les valeurs de I est Q.

Dans le cas d'un échantillonnage non-IQ il est possible de retrouver les valeurs de I est Q à partir des N échantillons du signal, avec N tel que $N\alpha$ soit multiple de $2\pi$, à partir des équations suivantes :

$$I = \frac{2}{N} \sum_{i=1}^{N} x_i \cos(i \times \alpha)$$

$$Q = \frac{2}{N} \sum_{i=1}^{N} x_i \sin(i \times \alpha)$$

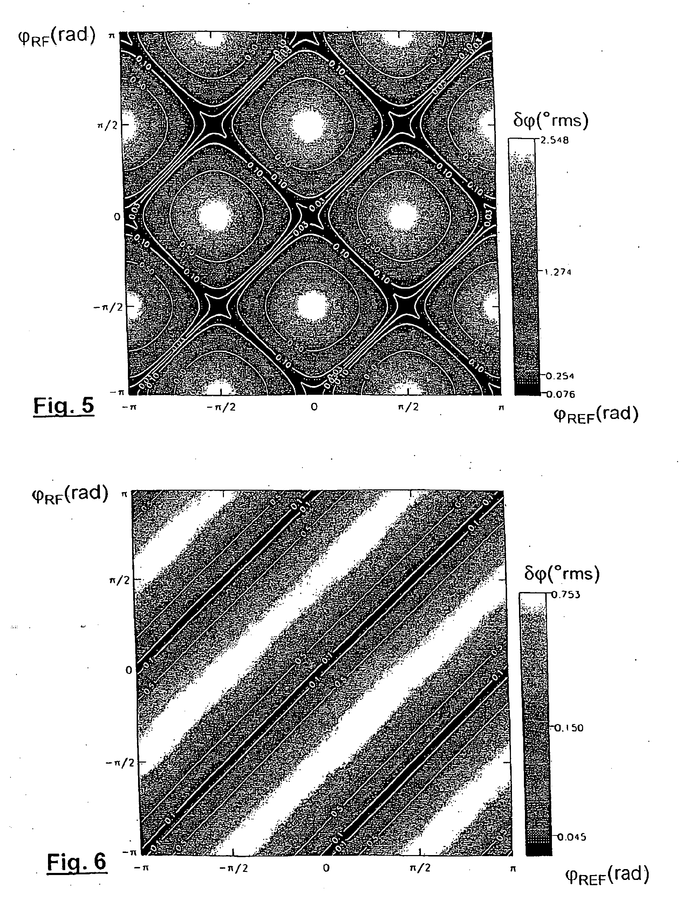

Ce sont ces équations qui ont été utilisées pour réaliser les simulations de la figure 6.

L'échantillonnage IQ est de loin le plus couramment utilisé, mais dans certains cas l'échantillonnage non-IQ peut s'avérer avantageux comme décrit dans le document [8].

La description mathématique de l'échantillonnage synchrone IQ on non-IQ reproduite ci-dessus ne tient pas compte de l'effet de la gigue-inévitable- du signal d'horloge d'échantillonnage. En général, on peut considérer que cette gigue introduit une erreur d'amplitude $\delta A$ et de phase $\delta\varphi$ dans la dérivation des propriétés du signal principal.

Le présent inventeur s'est rendu compte du fait que ces erreurs $\delta A$, $\delta\varphi$ dépendent de la phase du ou des signaux radiofréquence, ladite phase étant mesurée par rapport au signal d'horloge d'échantillonnage, et plus précisément par rapport à l'instant initial t=0 défini par le signal d'horloge d'échantillonnage. En particulier, en cas d'échantillonnage simple les erreurs $\delta A$, $\delta\varphi$ dépendent de la phase du signal principal, tandis qu'en cas de double échantillonnage ces erreurs sont fonction des phases du signal principal et du signal de référence.

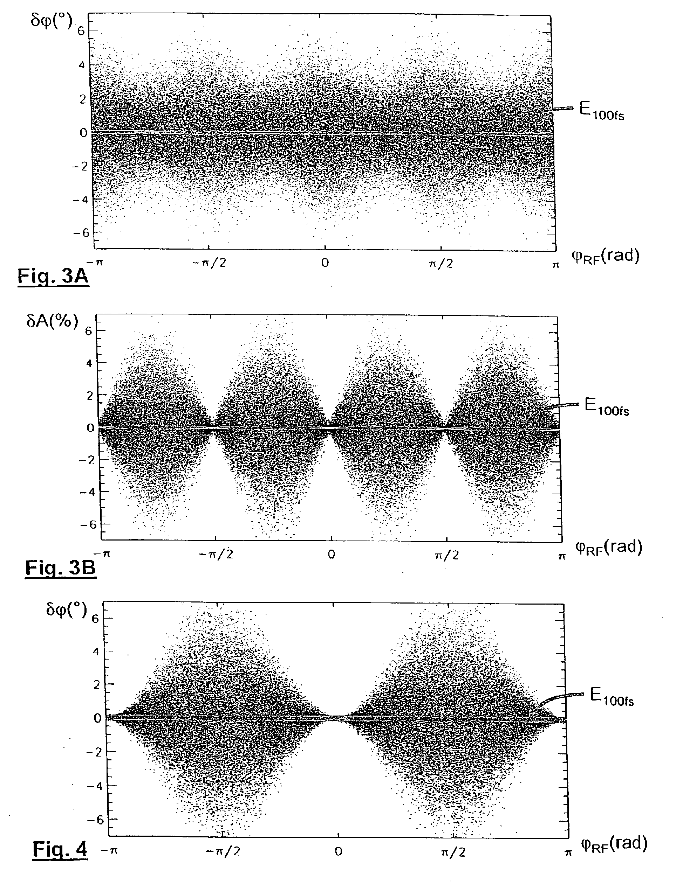

Les figures 3A et 3B illustrent les résultats de simulations de l'échantillonnage IQ d'un signal RF à 1 GHz par un ADC 14 bits parfait, mais dont l'horloge de déclanchement est soumise à une gigue de 5 ps (bruit blanc gaussien). Ces graphiques sont le résultat d'une simulation Monte-Carlo : chaque point représente un tirage aléatoire d'un signal de phase comprise entre $-\pi$ et $\pi$, que l'on échantillonne en IQ, pour mesurer son amplitude et sa phase et les comparer à leur valeurs réelles. Sur les ordonnées des graphes, les erreurs de mesure de phase (figure 3A) et d'amplitude (figure 3B) sont données.

Pour une phase donnée (en abscisse), la dispersion verticale des points de simulation est donc une représentation du bruit de mesure. Les erreurs de mesures simulées pour une gigue de 100 fs sont superposées (ligne continue $E_{100fs}$). Cette gigue est de l'ordre de grandeur des meilleures gigues d'ouverture propres aux codeurs analogique-numérique (ADC), que l'on constate sur les composants performants du marché actuellement : autrement dit, la ligne $E_{100fs}$ représente l'erreur qui serait obtenue si la gigue du signal d'horloge d'échantillonnage était négligeable. Ceci permet de visualiser à quel point une horloge de gigue 5 ps, dégrade la mesure, par rapport à ce qui serait possible avec une horloge de gigue négligeable mais un ADC réel.

On constate sur la figure 3B que le niveau de bruit sur la mesure de l'amplitude est extrêmement variable, selon la phase du signal mesuré. Ce bruit est minimal pour les phases $\varphi_{RF} = \pm k\dfrac{\pi}{2}$ (k entier), et il est maximal pour les phases $\varphi_{RF} = \dfrac{\pi}{4} \pm k\dfrac{\pi}{2}$.

On peut démontrer dans le cas d'une gigue ayant une caractéristique de bruit blanc gaussien, d'écart-type $\sigma_{jitt}$, que l'erreur relative maximale sur la mesure par échantillonnage IQ de l'amplitude d'un signal RF de fréquence f, en présence d'une gigue d'horloge d'écart-type $\sigma_{jitt}$ vaut, au voisinage $\dfrac{\pi}{4} \pm k\dfrac{\pi}{2}$ (k entier) :

$$\sigma\left(\frac{Y-A}{A}\right)_{max}(rms) = \sqrt{2}\pi f \times \sigma_{jitt} \text{ (en radians)}$$

Numériquement, à 1 GHz, une gigue de 5 ps rms produit un bruit de mesure sur l'amplitude d'environ 2,22 % rms.

Dans ces conditions, l'erreur relative minimale d'amplitude, vaut, au voisinage de $\pm k\dfrac{\pi}{2}$ (k entier) :

$$\sigma\left(\frac{Y-A}{A}\right)_{min} = (2\times\pi\times f\times\sigma_{jitt})^2 \text{ (en radians)}$$

Numériquement, à 1 GHz : Une gigue de 5 ps rms produit un bruit de mesure sur l'amplitude d'environ 0,1 % rms seulement.

Concernant le bruit sur la mesure de phase, la figure 3A indique que le bruit de mesure dû à la gigue de l'horloge varie avec la phase du signal, mais on peut démontrer pour des gigues gaussiennes que cette variation est d'un facteur $\sqrt{2}$ selon la phase.

Le bruit de mesure maximum sur la phase est obtenu pour des phases de $\pm k\dfrac{\pi}{2}$ (k entier) et vaut:

$\sigma_\varphi = 2\pi \times f \times \sigma_{jitt}$ (rad.) Numériquement, pour un signal RF à 1 GHz et une gigue de 5 ps : $\sigma_{j\varphi} = 1{,}8°$ au maximum.

Le bruit de mesure minimum sur la phase est obtenu pour des phases de $\dfrac{\pi}{4} \pm k\dfrac{\pi}{2}$ (k entier) et vaut :

$$\sigma_\varphi = \sqrt{2}\pi \times f \times \sigma_{jitt}$$ (rad.) Numériquement, pour un signal RF à 1 GHz et une gigue de 5 ps : $\sigma_{j\varphi} \approx 1{,}27°$ au minimum

Les figures 3A et 3B montrent que, moyennant un réglage de la phase du signal (ou de façon équivalente de la phase de l'horloge de conversion), par exemple à l'aide un déphaseur commercial, il est possible de rendre négligeable le bruit de mesure en amplitude affectant la mesure en simple échantillonnage IQ, ou de réduire d'environ 40% le bruit de mesure en phase.

La figure 4 donne des valeurs d'erreurs de phase issus de simulations similaires à celles effectuées en simple échantillonnage, mais cette fois en double échantillonnage : échantillonnage IQ simultané d'un signal RF à 1 GHz et d'une référence RF de même fréquence, par deux ADC 14 bits parfaits, avec une même horloge de déclanchement soumise à une gigue de 5 ps. La phase de la référence RF par rapport à l'horloge d'échantillonnage est de 0°. Le graphe donne l'erreur de mesure sur la différence de phase ($\varphi_{RF} - \varphi_{REF}$).

On voit sur cette figure que, dans le cas du double échantillonnage IQ, il existe des phases du signal RF pour lesquelles le bruit de mesure sur la phase devient très faible. Ces phases sont celles proches de $k\pi$ (k entier). Pour ces phases particulières, le bruit de mesure est équivalent au bruit dû à la gigue propre de l'ADC, on peut donc dire que l'on s'est affranchi de la gigue de l'horloge d'échantillonnage. En ce qui concerne l'erreur d'amplitude, en revanche, le passage au double échantillonnage n'introduit pas de changement qualitatif remarquable.

La figure 5 montre des résultats de simulation numérique, obtenus en donnant aux phases de la référence et du signal, l'ensemble des valeurs possibles entre $-\pi$ et $+\pi$. La gigue de l'horloge de conversion est toujours de 5 ps rms dans ces simulations ; la gigue d'ouverture des ADC est de 100 fs rms ; les signaux échantillonnés ont pour fréquence analogique 1 GHz. La figure 5 donne, en fonction de la phase du signal (en ordonnées) et de celle de la référence (en abscisses), le bruit de mesure sur la différence des phases mesurées par double-échantillonnage IQ. Ce bruit rms est donné en degrés à 1 GHz par l'échelle de gris. Sur le diagramme, on a représenté les contours délimitant les zones pour lesquelles les valeurs de bruits de mesure sont inférieures au bruit maximal d'un facteur 2 (courbes 0.5), 10 (courbes 0.1) et 33 (courbes 0.03).

La figure 5 indique qu'en double échantillonnage, il est possible d'obtenir des mesures de phase à très bas bruit, même à l'aide d'une horloge d'échantillonnage ayant une forte gigue. Si les phases du signal et de la référence, $\varphi_{RF}$ et $\varphi_{REF}$, sont telles que $\varphi_{REF} = \pm\varphi_{RF} \pm k\pi$ avec k entier, alors l'effet de la gigue d' l'horloge s'annule, et la précision de mesure n'est limitée que par les autres imperfections, comme la gigue propre d'ouverture du codeur, ou encore le bruit propre du codeur.

La figure 6 correspond à la figure 5 pour le cas d'un double échantillonnage non-IQ avec $\alpha=120°$. On voit que dans ce mode, il est également possible de s'affranchir de la gigue d'horloge, mais cette fois uniquement pour des phases liées par la relation : $\varphi_{REF} = \varphi_{RF} \pm k\pi$.

Les simulations précédentes ont toutes été faites en supposant que la gigue était un bruit blanc gaussien. En réalité, la gigue des composants numériques tels les PLL ou bien les DCM (« *Digital Clock Manager* », c'est à dire gestionnaire d'horloge numérique) de FPGA, est un bruit qui est très corrélé, notamment avec des composantes à basse fréquence. Il est possible de montrer que la prise en compte de la corrélation de la gigue ne modifie pas qualitativement les résultats décrits ci-dessus ; simplement, l'erreur résiduelle de phase s'avère être encore plus faible.

L'idée à la base de l'invention consiste à ajuster la phase du signal principal et/ou du signal de référence (en cas de double échantillonnage), notamment à l'aide de déphaseurs, pour supprimer ou diminuer l'effet de la gigue de l'horloge d'échantillonnage. Une excursion des déphaseurs de 180° (par rapport à la fréquence RF du signal d'intérêt) est suffisante, dans le cas général où l'on ne connait pas à priori les phases des signaux à traiter.

Le document [10] décrit, à titre d'exemple non limitatif, des déphaseurs analogiques pouvant convenir à la mise en oeuvre de l'invention dans certaines plages de fréquences.

Ainsi, un circuit selon l'invention peut être obtenu simplement en ajoutant un ou plusieurs déphaseurs au circuit de la figure 1 (simple échantillonnage IQ ou non-IQ) ou de la figure 2 (double échantillonnage IQ ou non-IQ).

Dans le cas du double échantillonnage, qui est le plus intéressant pour la réduction du bruit de mesure de la phase, le signal RF analogique Y(t) est échantillonné par le bloc échantillonneur - bloqueur-convertisseur analogique-numérique ADC1. Un signal de référence analogique R(t), de même fréquence que le signal RF à analyser est échantillonné par ADC2. Le signal de référence doit être entaché d'un bruit de phase aussi faible que possible pour avoir la précision de mesure la plus grande possible. En pratique, il s'agira par exemple d'un signal fourni par un simple oscillateur à quartz ou bien par un synthétiseur du commerce. Ce bruit de phase sera dans tous les cas nettement inférieur au bruit de phase de l'horloge d'échantillonnage, et dont on veut réduire les effets par la présente invention.

Les deux codeurs ADC1 et ADC2 sont déclenchés par la même horloge d'échantillonnage. On suppose que cette horloge a une gigue trop importante pour obtenir la précision voulue sur l'échantillonnage du signal RF. Dans les systèmes courants, l'horloge d'échantillonnage est synchrone du signal de référence, mais ce n'est pas obligatoire.

A partir des données numériques générées par les ADC, le processeur ou le FPGA réalise la démodulation IQ, ce qui revient à calculer l'amplitude et la phase du signal RF, par rapport à celles du signal de référence.

Plus généralement, il est possible d'utiliser un signal de référence R(t) ayant une fréquence $f_{REF}$ différente de celle du signal Y(t), mais commensurable, c'est à dire que $f_{REF}/f_{RF}=M_1/M_2$ avec $M_1$, $M_2$ entiers naturels non nuls. La principale différence est que, dans ces conditions, c'est l'erreur sur la mesure de $(\varphi_{RF} - \dfrac{f_{RF}}{f_{REF}}\varphi_{REF})$ qui est minimisé.

Il faut noter que, selon l'algorithme de démodulation utilisé, on peut aussi calculer l'amplitude du signal RF sans la rapporter à celle du signal de référence, en utilisant pour ce calcul les données de l'ADC1 seulement. En effet, si l'on souhaite par exemple appliquer la méthode à un accélérateur de particules, il faut noter que le signal de référence qui est distribué dans un accélérateur est un signal permettant de synchroniser les différents sous-systèmes, c'est donc une référence de phase mais pas forcément une référence d'amplitude.

Il faut aussi noter que le fait d'échantillonner la référence RF avec ADC2, permet de s'affranchir des dérives éventuelles en phase du système de production de l'horloge d'échantillonnage (CC), par exemple des dérives thermiques.

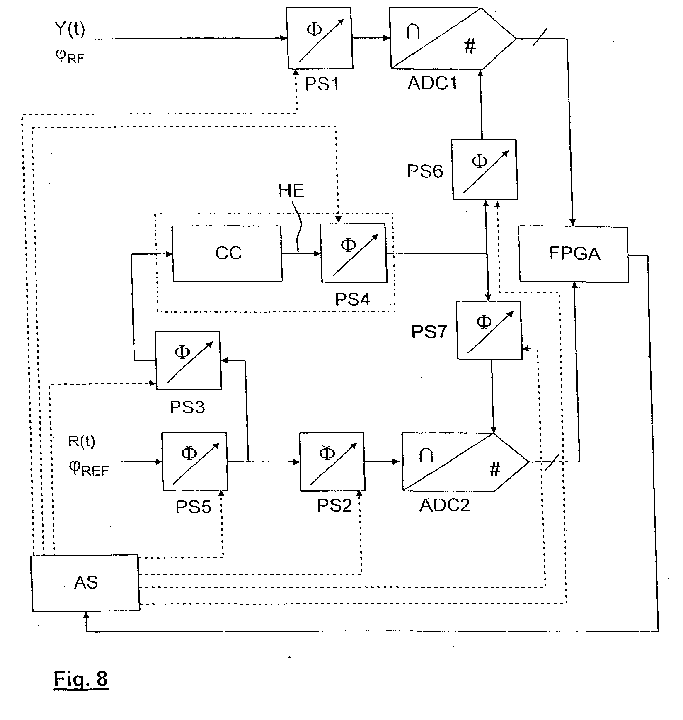

La figure 8 indique les emplacements possibles de déphaseurs PS1 - PS7, qui permettent de modifier la phase d'un ou de plusieurs signaux, de façon à se trouver dans une zone de la figure 5 (ou de la figure 6 si l'on fait du double-échantillonnage non-IQ), dans laquelle l'effet de la gigue sera réduit. En cas de simple échantillonnage, les emplacements possibles du (des) déphaseur(s) sont donnés par PS1, PS3, PS4, PS6.

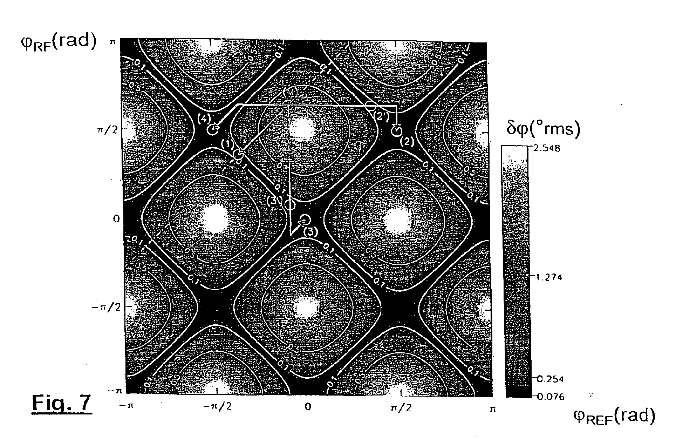

La figure 7 permet de comprendre l'action de ces déphaseurs. Sur cette figure, le point (M) représente la situation de départ : les phases $\varphi_{RF}$ et $\varphi_{REF}$ ont des valeurs aléatoires, $\varphi_{RF}$=115° et $\varphi_{REF}$=-15°, qui correspondent à un niveau d'erreur de phase élevé.

La solution la plus simple consiste à utiliser un seul déphaseur : dans le cas d'un échantillonnage IQ cela permet toujours d'atteindre un point de fonctionnement où le bruit de mesure sera plus faible, dans les « vallées » des diagrammes des figures 5 et 7.

Par exemple, l'utilisateur du seul déphaseur PS3 ou PS4 permet de se déplacer en diagonale sur le diagramme de la figure 7, du point (M) au point (1). L'utilisation du seul déphaseur PS2 ou PS7 permet de se déplacer horizontalement, sur le diagramme de la figure 7, du point (M) au point (2'). Tandis que l'utilisation du seul déphaseur PS1, PS5 ou PS6 permet de se déplacer verticalement, du point (M) au point (3').

L'utilisation du seul déphaseur PS4 peut s'avérer particulièrement avantageuse lorsque l'horloge d'échantillonnage est générée par un circuit numérique tel que le DCM d'un FPGA, car dans ce cas le déphaseur peut être déjà intégré à ce circuit, comme c'est le cas pour le Virtex-5 de Xilinx. On peut donc faire le réglage de phase sans aucun composant additionnel à implanter dans l'électronique de mesure et de traitement.

L'inconvénient à n'utiliser qu'un seul déphaseur est que, dans le cas général, on va atteindre une « vallée » étroite : le bruit de mesure sera faible tant que le réglage du déphaseur est parfait, mais se dégradera rapidement avec un très faible dérèglement. Il sera par ailleurs difficile d'atteindre un réglage optimal si le déphasage introduit par le déphaseur varie par des pas discrets. A titre d'exemple, le pas élémentaire du déphasage programmable est de 1,46 ns pour un FPGA Virtex-5 générant une horloge d'échantillonnage à 266 MHz sur une sortie PLL, soit 5,3° en phase pour un signal RF à 1 GHz.

Il faut souligner que l'utilisation des déphaseurs aux emplacements PS6 et PS7 est possible mais n'est pas recommandée, car ces dispositifs sont susceptibles d'ajouter chacun une contribution en gigue, qui ne sera pas commune sur les horloges arrivant aux deux ADC, et dont l'effet ne pourra donc pas être réduit par le dispositif.

L'observation des figures 5 et 7 montre que, parmi tous les réglages possibles correspondant à la relation $\varphi_r = \pm\varphi_s \pm k\pi$, certains points de fonctionnement sont plus intéressants que d'autres. En effet, il existe des zones à faible erreur de phase assez larges autour des points :

$$\begin{cases} \varphi_{RF} = 0 \pm k\dfrac{\pi}{2}, \text{avec k entier quelconque} \\ \varphi_{REF} = \pm\varphi_{RF} \pm k\pi \end{cases}$$

En outre, ces points de fonctionnement correspondent aux valeurs de phase du signal « principal » pour lesquelles le bruit sur la mesure d'amplitude est minimum.

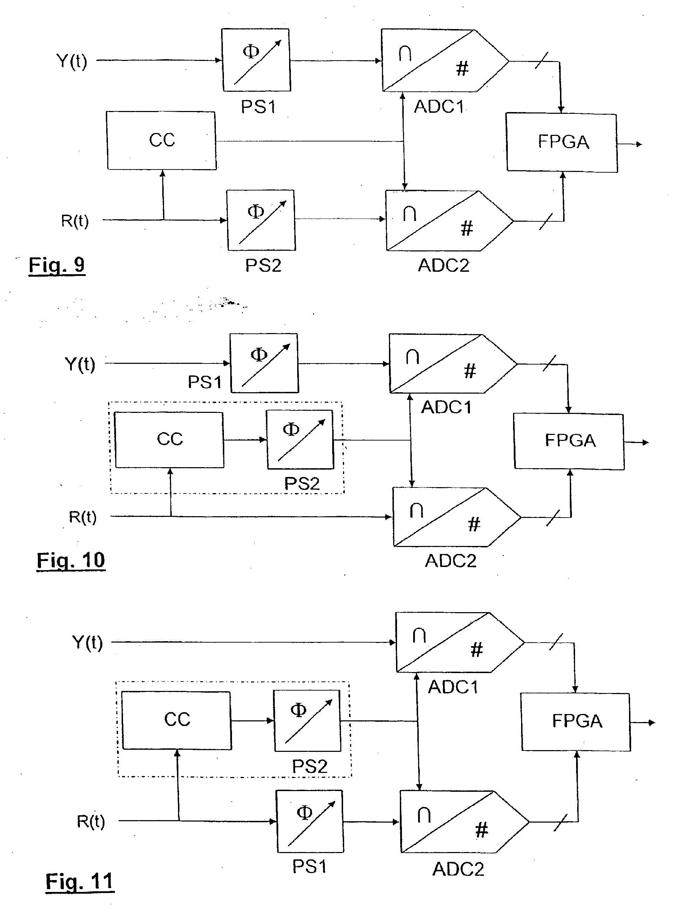

Il s'agit par exemple des points (2), (3) et (4) sur la figure 7. En général, pour atteindre ces points à partir d'un point de départ (M) arbitraire, il faut au moins deux déphaseurs permettant d'introduire un déphasage indépendant du signal principal et du signal de référence. Ce résultat peut être obtenu en utilisant un premier déphaseur sur le chemin du signal principal et un deuxième déphaseur sur le chemin du signal de référence (voir la figure 9) ; ou un premier déphaseur sur le chemin du signal d'échantillonnage (qui introduit un déphasage des deux signaux à échantillonner, dont les phases sont définies justement par rapport au signal d'horloge d'échantillonnage) et un deuxième déphaseur sur le chemin du signal principal ou de référence (voir les figures 10 et 11).

Par exemple, le point (2) est atteint en combinant un déplacement horizontal (déphaseur PS2 ou - mais c'est déconseillé - PS7) et un déplacement vertical (déphaseur PS1, PS5 ou - mais c'est déconseillé-PS6). Le point (3) peut être atteint en combinant un déplacement vertical et un déplacement en diagonale (PS3 ou PS4). Le point (4) peut être atteint en combinant un déplacement horizontal et un déplacement en diagonale.

En pratique, on pourra adopter par exemple le schéma de la figure 9, de la figure 10 ou de la figure 11, permettant d'atteindre respectivement les zones (2) et (3) et (4) à partir du point de départ (M) de la figure 7 en parcourant les chemins indiqués.

Les schémas des figures 10 et 11 sont particulièrement intéressants car PS2 peut être un déphaseur numérique déjà intégré au circuit de production de l'horloge d'échantillonnage, par exemple s'il s'agit du DCM d'un FPGA. La mise en oeuvre de l'invention ne nécessite alors que l'ajout d'un seul composant, un déphaseur analogique sur la voie principale de mesure (figure 10) ou bien sur la voie de mesure de la référence RF (figure 11). Un avantage du schéma de la figure 10 est, qu'à partir d'un réglage initial, il suffit de commander le seul déphaseur PS1 pour maintenir la mesure optimale. En effet, seule la phase du signal RF d'intérêt est susceptible de varier. Un avantage de la configuration de la figure 11 est qu'aucun composant additionnel n'est introduit dans la voie de mesure principale. Par contre, lorsque la phase du signal RF d'intérêt varie, il faut ajuster les deux déphaseurs PS1 et PS2 si l'on veut se maintenir au voisinage d'un point tel les points (2), (3) ou (4) de la figure 7.

La figure 6 montre qu'en cas d'échantillonnage synchrone non-IQ il n'existe pas de points de fonctionnement particuliers, de plus grande stabilité de réglage, comme c'était le cas pour l'échantillonnage IQ. Dans ces conditions, disposer de deux déphaseurs n'est pas utile. Un seul déphaseur qui permet de se déplacer verticalement ou horizontalement sur la figure 6 permet d'optimiser le bruit sur la mesure de phase. Les emplacements possibles sont PS1, PS2, PS5, PS6 et PS7, dans le schéma de la figure 8. Pour le double échantillonnage non-IQ, dans le cas où le signal principal et le signal de référence ont la même fréquence, les emplacements PS3 et PS4 des déphaseurs sont sans intérêt du point de vue de notre propos : en effet, leur action serait un déplacement selon une droite parallèle à la droite $\varphi_{REF} = \varphi_{RF}$, dans le diagramme de la figure 6, sans effet sur le bruit de mesure.

On remarque que, dans le cas de l'échantillonnage non-IQ, les « vallées » sont toujours assez étroites. Donc, du point de vue de la stabilité du réglage, l'échantillonnage IQ est supérieur.

Pour fonctionner de façon optimale, la méthode suppose en général que la différence de phase entre le signal RF et la référence RF, varie peu, de façon à rester dans une zone à faible erreur de phase. En pratique, dans le cas général, on peut donc imaginer que les déphaseurs utilisés soient asservis, pour respecter cette condition, en suivant les changements de phase du signal RF d'intérêt. Sur le schéma de la figure 8, la référence AS indique un tel dispositif d'asservissement. En pratique il peut s'agir du même processeur ou FPGA qui réalise les démodulations des signaux.

Il existe cependant des applications particulières où un tel asservissement n'est pas nécessaire, ce qui simplifie la mise en oeuvre d'un démodulateur selon l'invention. Il s'agit en particulier du contrôle des champs RF des cavités des accélérateurs de particules. En effet, le but de l'électronique RF de contrôle de ces accélérateurs, est justement, pour chaque cavité, d'asservir son champ à une amplitude et à une phase données, la phase se rapportant à un signal de référence servant à synchroniser tous les équipements. Autrement dit, dans un mode de fonctionnement donné de l'accélérateur, chaque cavité est le siège d'un champ RF qui a une phase et une amplitude constantes par rapport au signal de référence. On peut donc régler le ou les déphaseurs de façon à minimiser le bruit de mesure dû à la gigue d'horloge, et garder ces réglages constants pour le fonctionnement de l'accélérateur dans ce mode.

Références :

[1] Brad Brannon, Sampled Systems and the Effects of Clock Phase Noise and Jitter, Analog Devices Application Note AN-756, 2004

[2] Tina Harriet Smilkstein, Jitter Reduction on High-Speed Clock Signals, Technical Report No. UCB/EECS-2007-96, University of California at Berkeley.

[3] S. N. Simrock, Low Level Radio Frequency control system for the european XFEL, MIXDES 2006, Gdynia, POLAND, 22 - 24 Juin 2006

[4] P. de Antoni, P. Galdemard, O. Piquet, S. Sube, Y.Mariette, M.Luong, M. Di Giacomo, The architecture of the low level RF electronics for Spiral 2, Low Level Radio Frequency Workshop, 22-25 Octobre 2007- Knoxville, TN, USA
[5] Method and apparatus for analog-to-digital conversion by combining digital sample values, US Patent 6,317,071.
[6] M. Grecki, T. Jezynski, A. Brandt, Estimation of IQ vector components of RF field - Theory and implementation, MIXDES 2005, Krakow, Poland, 22-25 Juin 2005
[7] Subharmonic quadrature sampling receiver and design, US Patent 5,937,013.
[8] L. Doolittle, H. Ma, M.S. Champion, Digital low-level RF control using non-IQ sampling, Proceedings of LINAC 2006, Knoxville, Tennessee USA.
[9] L. Doolittle, Low-Level RF Control System Design And Architecture, Proceedings of APAC 2007, Indore, India.
[10] Analog Phase Shifter Using Cascaded Voltage Tunable Capacitor US Patent 7,276,993.

**Revendications**

1. Procédé de démodulation d'un signal radiofréquence (Y) comportant les étapes consistant à :

   - procurer un signal d'horloge d'échantillonnage (HE) synchrone dudit signal radiofréquence à démoduler ;
   - échantillonner ledit signal radiofréquence au moyen dudit signal d'horloge d'échantillonnage ; et
   - traiter les échantillons ainsi obtenus pour déterminer la phase et/ou l'amplitude dudit signal radiofréquence ;

   **caractérisé en ce qu'**il comporte également une étape d'ajustement de la phase, mesurée par rapport au signal d'horloge d'échantillonnage, dudit signal à démoduler et/ou d'un signal synchrone de référence (R) par rapport auquel ce signal est démodulé, de manière à minimiser l'erreur de phase et/ou d'amplitude provoqué par une gigue dudit signal d'horloge d'échantillonnage.

2. Procédé selon la revendication 1 dans lequel ledit signal radiofréquence présente une porteuse à une fréquence $f_{RF}$ et dans lequel ledit signal d'horloge d'échantillonnage présente une fréquence $f_S= 4/(2k+1)\cdot f_{RF}$ où k est un entier naturel, moyennant quoi ledit échantillonnage est un échantillonnage de type IQ.

3. Procédé selon la revendication 1 dans lequel ledit signal radiofréquence présente une porteuse à une fréquence $f_{RF}$ et dans lequel ledit signal d'horloge d'échantillonnage présente une fréquence $f_S= N_1/N_2 \cdot f_{RF}$ où $N_1$ et $N_2$ sont des entiers naturels différents tels qu'il n'existe pas d'entier naturel non nul $N_3$ pour lequel $N_1/N_2=2/N_3$ et en outre $f_S=N_1/N_2\cdot f_{RF}\neq 4/(2k+1)\cdot f_{RF}$ où k est un entier naturel, moyennant quoi ledit échantillonnage est un échantillonnage de type non-IQ.

4. Procédé selon l'une des revendications 2 ou 3 dans lequel la phase dudit signal radiofréquence, mesurée par rapport au signal d'échantillonnage, est ajustée à une valeur aussi proche que possible d'une valeur cible choisie entre :

   ■ $\pm k\pi/2$ avec k entier, de manière à minimiser l'erreur de mesure d'amplitude provoquée par la gigue dudit signal d'horloge d'échantillonnage ; et
   ■ $\pi/4\pm k\pi/2$ avec k entier, de manière à minimiser l'erreur de mesure de phase provoquée par la gigue dudit signal d'horloge d'échantillonnage

5. Procédé selon la revendication 2 comportant l'échantillonnage IQ dudit signal radiofréquence dit signal principal (Y) ainsi que d'un second signal radiofréquence (R) synchrone avec ledit signal principal, dit signal de référence, et le traitement des échantillons ainsi obtenus pour déterminer les variations de phase dudit signal principal par rapport audit signal de référence, dans lequel la phase $\varphi_{RF}$ de la porteuse dudit signal principal et la phase $\varphi_{REF}$ dudit signal de référence sont ajustées de manière à minimiser l'erreur de mesure de la grandeur

$$\left(\varphi_{RF} - \frac{f_{RF}}{f_{REF}} \varphi_{REF}\right),$$ où $f_{REF}$ est la fréquence du signal de référence, qui est commensurable avec celle du signal principal.

6. Procédé selon la revendication 5 dans lequel la phase $\varphi_{RF}$ dudit signal principal et celle $\varphi_{REF}$ dudit signal de référence sont ajustées de manière à approcher autant que possible la relation $\varphi_{REF}=\pm\varphi_{RF}\pm k\pi$ avec k entier.

7. Procédé selon la revendication 6 dans lequel la phase $\varphi_{RF}$ dudit signal principal et celle $\varphi_{REF}$ dudit signal de référence sont ajustées de manière à approcher autant que possible les relations : $\varphi_{RF} = \pm k\pi/2$ et $\varphi_{REF} = \pm\varphi_{RF}\pm k'\pi$ avec k, k' entiers.

8. Procédé selon la revendication 3 comportant l'échantillonnage non-IQ d'un premier signal radiofréquence (Y) dit signal principal ainsi que d'un second signal radiofréquence (R) synchrone avec ledit signal principal, dit signal de référence, et le traitement des échantillons ainsi obtenus pour déterminer les variations de phase dudit signal principal par rapport audit signal de référence, dans lequel la phase $\varphi_{RF}$ de la porteuse dudit signal principale et la phase $\varphi_{REF}$ dudit signal de référence sont ajustées de manière à minimiser l'erreur de mesure de la grandeur

$$(\varphi_{RF} - \frac{f_{RF}}{f_{REF}}\varphi_{REF}),$$ où $f_{REF}$ est la fréquence du signal de référence, qui est commensurable avec celle du signal principal.

9. Procédé selon la revendication 8 dans lequel la phase $\varphi_{RF}$ dudit signal principal et celle $\varphi_{REF}$ dudit signal de référence sont ajustées de manière à approcher autant que possible la relation $\varphi_{REF}=\varphi_{RF}\pm k\pi$ avec k entier.

10. Procédé selon l'une des revendications précédentes dans lequel ledit ajustement de phase est obtenu au moyen d'au moins deux déphaseurs prévus pour introduire des déphasages indépendants dudit signal principal et dudit signal de référence.

11. Circuit démodulateur comportant :

- une première entrée pour un signal radiofréquence (Y) à démoduler ;
- un générateur (CC) de signal d'horloge d'échantillonnage (HE) synchrone dudit signal radiofréquence;
- un premier échantillonneur (ADC1) dudit signal radiofréquence, piloté par ledit signal d'horloge d'échantillonnage ; et
- des moyens de traitement (FPGA) des échantillons ainsi obtenus pour déterminer la phase et/ou l'amplitude dudit signal radiofréquence ;

**caractérisé en ce qu'**il comporte au moins un déphaseur (PS1 - PS7) ajustable dudit signal radiofréquence, d'un signal de référence (R) synchrone par rapport auquel ce signal est démodulé et/ou dudit signal d'horloge d'échantillonnage (HE).

12. Circuit selon la revendication 11 comportant également

- une entrée pour un second signal radiofréquence (R), dit signal de référence ; et
- un second échantillonneur (ADC2), piloté par ledit signal d'horloge d'échantillonnage, pour échantillonner ledit signal de référence ;

dans lequel lesdits moyens de traitement des échantillons sont adaptés pour déterminer une information de phase relative dudit signal principal par rapport audit signal de référence à partir des échantillons fournis par lesdits premier et second échantillonneurs.

13. Circuit selon la revendication 12 dans lequel ledit générateur de signal d'horloge d'échantillonnage (CC) est piloté par ledit signal de référence.

14. Circuit selon l'une des revendications 12 ou 13 comportant également des moyens de commande (AS) pour ajuster ledit ou chaque déphaseur de manière à maintenir la phase et/ou la différence de phase dudit signal principal et dudit signal de référence à l'intérieur d'une plage de valeurs prédéterminées.

15. Circuit selon l'une des revendications 12 à 14 comportant au moins deux déphaseurs prévus pour introduire des déphasages indépendants dudit signal principal et dudit signal de référence.

**Patentansprüche**

1. Verfahren zur Demodulation eines Funkfrequenzsignals (Y) mit den folgenden Schritten:

- Bereitstellen eines Abtasttaktsignals (HE), das synchron mit dem zu demodulierenden Funkfrequenzsignal ist;
- Abtasten des Funkfrequenzsignals mit Hilfe des Abtasttaktsignals; und
- Verarbeiten der so erhaltenen Abtastungen zum Ermitteln der Phase und/oder Amplitude des Funkfrequenzsignals;

**dadurch gekennzeichnet, dass** das Verfahren ferner folgenden Schritt umfasst: Einstellen der in Bezug auf das Abtasttaktsignal gemessenen Phase des zu demodulierenden Signals und/oder eines synchronen Referenzsignals (R), in Bezug auf welches dieses Signal demoduliert wird, derart, dass ein durch einen Jitter des Abtasttaktsignals verursachter Phasen- und/oder Amplitudenfehler minimiert wird.

2. Verfahren nach Anspruch 1, bei dem das Funkfrequenzsignal einen Träger mit einer Frequenz $f_{RF}$ aufweist und das Abtasttaktsignal eine Frequenz $f_s=4/(2k+1)\cdot f_{RF}$ aufweist, wobei k eine natürliche Zahl ist, womit es sich bei der Abtastung um eine Abtastung vom I/Q-Typ handelt.

3. Verfahren nach Anspruch 1, bei dem das Funkfrequenzsignal einen Träger mit einer Frequenz $f_{RF}$ aufweist und das Abtasttaktsignal eine Frequenz $f_s=N_1/N_2\cdot f_{RF}$ aufweist, wobei $N_1$ und $N_2$ unterschiedliche natürliche Zahlen sind, derart, dass es keine von Null verschiedene natürliche Zahl $N_3$ gibt, für die gilt: $N_1/N_2=2/N_3$ und ferner $f_s=N_1/N_2\cdot f_{RF}\neq 4/(2k+1)\cdot f_{RF}$, wobei k eine natürliche Zahl ist, womit es sich bei der Abtastung nicht um eine Abtastung vom I/Q-Typ handelt.

4. Verfahren nach einem der Ansprüche 2 oder 3, bei dem die in Bezug auf das Abtastsignal gemessene Phase des Funkfrequenzsignals auf einen Wert eingestellt wird, der so nahe wie möglich an einem Zielwert liegt, der ausgewählt ist aus:

    ■ $\pm k\pi/2$, wobei k eine ganze Zahl ist, derart, dass ein vom Jitter des Abtasttaktsignals verursachter Amplitudenmessfehler minimiert wird; und
    ■ $\pi/4\pm k\pi/2$, wobei k eine ganze Zahl ist, derart, dass ein vom Jitter des Abtasttaktsignals verursachter Phasenmessfehler minimiert wird.

5. Verfahren nach Anspruch 2, welches die I/Q-Abtastung des als Hauptsignal (Y) bezeichneten Funkfrequenzsignals und eines mit dem Hauptsignal synchronen zweiten Funkfrequenzsignals (R) umfasst sowie die Verarbeitung der so erhaltenen Abtastungen zum Ermitteln der Phasenänderungen des Hauptsignals gegenüber dem Referenzsignal, wobei die Phase $\varphi_{RF}$ des Trägers des Hauptsignals und die Phase $\varphi_{REF}$ des Referenzsignals derart eingestellt werden, dass ein Fehler beim Messen der Größe $\left(\varphi_{RF} - \dfrac{f_{RF}}{f_{REF}}\, \varphi_{REF}\right)$ minimiert wird, wobei $f_{REF}$ die mit der Frequenz des Hauptsignals kommensurable Frequenz des Referenzsignals ist.

6. Verfahren nach Anspruch 5, bei dem die Phase $\varphi_{RF}$ des Hauptsignals und die Phase $\varphi_{REF}$ des Referenzsignals derart eingestellt werden, dass sie sich soweit wie möglich an die Beziehung $\varphi_{REF}=\pm\varphi_{RF}\pm k\pi$ annähern, wobei k eine ganze Zahl ist.

7. Verfahren nach Anspruch 6, bei dem die Phase $\varphi_{RF}$ des Hauptsignals und die Phase $\varphi_{REF}$ des Referenzsignals derart eingestellt werden, dass sie sich soweit wie möglich an die Beziehungen $\varphi_{RF}=\pm k\pi/2$ und $\varphi_{REF}=\pm\varphi_{RF}\pm k'\pi$ annähern, wobei k, k' ganze Zahlen sind.

8. Verfahren nach Anspruch 3, welches umfasst: eine nicht-I/Q-Abtastung eines als Hauptsignal bezeichneten ersten Funkfrequenzsignals (Y) und eines mit dem Hauptsignal synchronen und als Referenzsignal bezeichneten zweiten Funkfrequenzsignals (R) sowie die Verarbeitung der so erhaltenen Abtastungen zum Ermitteln der Phasenänderungen des Hauptsignals gegenüber dem Referenzsignal, wobei die Phase $\varphi_{RF}$ des Trägers des Hauptsignals und die Phase $\varphi_{REF}$ des Referenzsignals derart eingestellt werden, dass ein Fehler beim Messen der Größe $\left(\varphi_{RF} - \dfrac{f_{RF}}{f_{REF}}\, \varphi_{REF}\right)$ minimiert wird, wobei $f_{REF}$ die mit der Frequenz des Hauptsignals konzmensurable Frequenz des Referenzsignals ist.

9. Verfahren nach Anspruch 8, bei dem die Phase $\varphi_{RF}$ des Hauptsignals und die Phase $\varphi_{REF}$ des Referenzsignals derart eingestellt werden, dass sie sich soweit wie möglich an die Beziehung $\varphi_{REF}=\varphi_{RF}\pm k\pi$ annähern, wobei k

eine ganze Zahl ist.

10. Verfahren nach einem der vorhergehenden Ansprüche, bei dem die Phaseneinstellung mit Hilfe von mindestens zwei Phasenschiebern erhalten wird, die vorgesehen sind, um vom Hauptsignal und Referenzsignal unabhängige Phasenverschiebungen einzuführen.

11. Demodulatorschaltung mit:

- einem ersten Eingang für ein zu demodulierendes Funkfrequenzsignal (Y);
- einem Generator (CC) zur Erzeugung eines mit dem Funkfrequenzsignal synchronen Abtasttaktsignals (HE);
- einem ersten Abtaster (ADC1) des Funkfrequenzsignals, der durch das Abtasttaktsignal gesteuert wird; und
- einer Einrichtung (FPGA) zum Verarbeiten der so erhaltenen Abtastungen zum Ermitteln der Phase und/oder Amplitude des Funkfrequenzsignals;

**dadurch gekennzeichnet, dass** sie mindestens einen einstellbaren Phasenschieber (PS1-PS7) des Funkfrequenzsignals, eines synchronen Referenzsignals (R), in Bezug auf welches dieses Signal demoduliert wird, und/oder des Abtasttaktsignals (HE) umfasst.

12. Schaltung nach Anspruch 11, ferner mit:

- einem Eingang für ein als Referenzsignal bezeichnetes zweites Funkfrequenzsignal (R); und
- einem von dem Abtasttaktsignal gesteuerten zweiten Abtaster (ADC2) zum Abtasten des Referenzsignals;

wobei die Einrichtung zum Verarbeiten der Abtastungen ausgelegt ist, um eine relative Phaseninformation des Hauptsignals in Bezug auf das Referenzsignal aus Abtastungen zu ermitteln, die von dem ersten und zweiten Abtaster bereitgestellt werden.

13. Schaltung nach Anspruch 12, bei der der Generator (CC) zur Erzeugung eines Abtasttaktsignals von dem Referenzsignal gesteuert wird.

14. Schaltung nach einem der Ansprüche 12 oder 13, ferner mit einer Steuereinrichtung (AS) zum Einstellen des oder jedes Phasenschiebers derart, dass die Phase und/oder Phasendifferenz des Hauptsignals und des Referenzsignals innerhalb eines Bereichs vorbestimmter Werte gehalten wird.

15. Schaltung nach einem der Ansprüche 12 bis 14 mit mindestens zwei Phasenschiebern, die vorgesehen sind, um vom Hauptsignal und Referenzsignal unabhängige Phasenverschiebungen einzuführen.

**Claims**

1. A method of demodulating a radiofrequency signal (Y), the method comprising the steps consisting in:

· providing a sampling clock signal (HE) that is synchronous with said radiofrequency signal for demodulating;
· sampling said radiofrequency signal by means of said sampling clock signal; and
· processing the samples obtained in this way to determine the phase and/or the amplitude of said radiofrequency signal;

the method being **characterized in that** it also includes a step of adjusting the phase, measured relative to the sampling clock signal, of said signal for demodulating and/or of a synchronous reference signal (R) relative to which said signal is demodulated, in such a manner as to minimize the phase and/or amplitude error caused by jitter of said signal clock signal.

2. A method according to claim 1, wherein said radiofrequency signal presents a carrier at the frequency $f_{RF}$ and wherein said sampling clock signal presents a frequency $f_s=4/(2k+1) \cdot f_{RF}$, where $\underline{k}$ is a natural integer, whereby said sampling is IQ-type sampling.

3. A method according to claim 1, wherein said radiofrequency signal presents a carrier at the frequency $f_{RF}$ and wherein said sampling clock signal presents a frequency $f_s=N_1/N_2 \cdot f_{RF}$ where $N_1$ and $N_2$ are different natural integers such that there does not exist any non-zero natural integer $N_3$ for which $N_1/N_2=2/N_3$ and further $f_s=N_1/N_2 \cdot f_{RF} \neq 4(2k+1) \cdot f_{RF}$ where $\underline{k}$ is a natural integer, whereby said sampling is non-IQ type sampling.

4. A method according to any one of claims 2 to 3, wherein the phase of said radiofrequency signal as measured relative to the sampling signal is adjusted to a value that is as close as possible to a target value selected from:

· $\pm k\pi/2$ for integer $\underline{k}$, so as to minimize the amplitude measurement error caused by jitter of said sampling clock signal; and
· $\pi/4 \pm k\pi/2$ for integer $\underline{k}$, so as to minimize the phase measurement error caused by the jitter of said sampling clock signal.

5. A method according to claim 2, comprising IQ sampling of said radiofrequency signal that is referred to as the main signal (Y), and of a second radiofrequency signal (R) that is synchronous with said main signal and that is referred to as the reference signal, and processing samples as obtained in this way to determine the phase variations of said main signal relative to said reference signal, wherein the phase $\varphi_{RF}$ of the carrier of said main signal and the phase $\varphi_{REF}$ of said reference signal are adjusted in such a manner as to minimize the error in the measurement of:

$$(\varphi_{RF} - \frac{f_{RF}}{f_{REF}} \varphi_{REF})$$

where $f_{REF}$ is the frequency of the reference signal, which frequency is commensurable with the frequency of the main signal.

6. A method according to claim 5, wherein the phase $\varphi_{RF}$ of said main signal and the phase $\varphi_{REF}$ of said reference signal are adjusted in such a manner as to come as close as possible to the relationship $\varphi_{REF}=\pm\varphi_{RF}\pm k\pi$ with integer $\underline{k}$.

7. A method according to claim 6, wherein the phase $\varphi_{RF}$ of said main signal and the phase $\varphi_{REF}$ of said reference signal are adjusted in such a manner as to come as close as possible to the following relationships:

$$\varphi_{RF} = \pm k\pi/2 \ \ \text{and} \ \ \varphi_{REF} = \pm\varphi_{RF}\pm k' \pi$$

and

$$\varphi_{REF} = \pm\varphi_{REF}\pm k' \pi$$

with integer $\underline{k}$ and k'.

8. A method according to claim 3, including non-IQ sampling of a first radiofrequency signal (Y) that is referred to as the main signal, and of a second radiofrequency signal (R) that is synchronous with said main signal and that is referred to as the reference signal, and processing samples as obtained in this way to determine the phase variations of said main signal relative to said reference signal, wherein the phase $\varphi_{RF}$ of the carrier of said main signal and the phase $\varphi_{REF}$ of said reference signal are adjusted in such a manner as to minimize the error in the measurement of the magnitude:

$$(\varphi_{RF} - \frac{f_{RF}}{f_{REF}} \varphi_{REF})$$

where $f_{REF}$ is the frequency of the reference signal, which frequency is commensurable with the frequency of the main signal.

9. A method according to claim 8, wherein the phase $\varphi_{RF}$ of said main signal and the phase $\varphi_{REF}$ of said reference signal are adjusted in such a manner as to come as close as possible to the relationship $\varphi_{REF} = \pm \varphi_{RF} \pm k\pi$ with integer $\underline{k}$.

10. A method according to any preceding claim, wherein said phase adjustment is obtained by means of at least two phase shifters for introducing independent phase shifts of said main signal and of said reference signal.

11. A demodulator circuit comprising:

· a first input for a radiofrequency signal (Y) for demodulating;
· a generator (CC) for generating a sampling clock signal (HE) that is synchronous with said radiofrequency signal;
· a first sampler (ADC1) for sampling said radiofrequency signal under the control of said sampling clock signal; and
· processor means (FPGA) for processing samples as obtained in this way in order to determine the phase and/or the amplitude of said radiofrequency signal;

the circuit being **characterized in that** it includes at least one adjustable phase shifter (PS1 - PS7) for shifting said radiofrequency signal, a synchronous reference signal (R) relative to which said signal is demodulated, and/or said sampling clock signal (HE).

12. A circuit according to claim 11, also including:

· an input for a second radiofrequency signal (R) referred to as the reference signal; and
· a second sampler (ADC2) controlled by said sampling clock signal in order to sample said reference signal;

wherein said sample processor means are adapted to determine phase information relating to said main signal relative to said reference signal on the basis of samples provided by said first and second samplers.

13. A circuit according to claim 12, wherein said sampling clock signal generator (CC) is controlled by said reference signal.

14. A circuit according to claim 12 or claim 13, also including control means (AS) for adjusting said or each phase shifter in such a manner as to maintain the phase and/or the phase difference of said main signal and of said reference signal within a predetermined range of values.

15. A circuit according to any one of claims 12 to 14, including at least two phase shifters designed to introduce independent phase shifts of said main signal and of said reference signal.

Y(t)
$\varphi_{RF}$

ADC

FPGA

I,Q
A, $\varphi$

R(t)
$\varphi_{REF}$

CC

HE

Fig. 1

Y(t)
$\varphi_{RF}$

ADC1

CC

FPGA

$I_{RF}, Q_{RF}$
$A_{RF}, \varphi_{RF}$

$I_{REF}, Q_{REF}$
$A_{REF}, \varphi_{REF}$

R(t)
$\varphi_{REF}$

ADC2

Fig. 2

**Fig. 3A**

**Fig. 3B**

**Fig. 4**

Fig. 5

Fig. 6

φ_RF(rad)

**Fig. 7**

δφ(°rms)

φ_REF(rad)

**Fig. 8**

Fig. 9

Fig. 10

Fig. 11

## RÉFÉRENCES CITÉES DANS LA DESCRIPTION

**Documents brevets cités dans la description**

- US 6317071 B
- US 5937013 A
- US 7276993 B

**Littérature non-brevet citée dans la description**

- **BRAD BRANNON.** Sampled Systems and the Effects of Clock Phase Noise and Jitter. *Analog Devices Application Note AN-756,* 2004
- **TINA HARRIET SMILKSTEIN.** Jitter Reduction on High-Speed Clock Signals. *Technical Report No. UCB/EECS-2007-96*
- **S. N. SIMROCK.** Low Level Radio Frequency control system for the european XFEL. *MIXDES 2006,* 22 Juin 2006
- **P. DE ANTONI ; P. GALDEMARD ; O. PIQUET ; S. SUBE ; Y.MARIETTE ; M.LUONG ; M. DI GIACOMO.** The architecture of the low level RF electronics for Spiral 2. *Low Level Radio Frequency Workshop,* 22 Octobre 2007
- **M. GRECKI ; T. JEZYNSKI ; A. BRANDT.** Estimation of IQ vector components of RF field - Theory and implementation. *MIXDES 2005,* 22 Juin 2005
- **L. DOOLITTLE ; H. MA ; M.S. CHAMPION.** Digital low-level RF control using non-IQ sampling. *Proceedings of LINAC 2006,* 2006
- **L. DOOLITTLE.** Low-Level RF Control System Design And Architecture. *Proceedings of APAC 2007,* 2007